# EUROPEAN PATENT SPECIFICATION

(11) **EP 4 621 379 B1**
(45) Date of publication and mention of the grant of the patent: **29.07.2026**
(21) Application number: 25163566.0
(22) Date of filing: 13.03.2025
(51) Int. Cl.: G01N 1/32, H01J 37/20

(54) **JIG**
SPANNVORRICHTUNG
GABARIT

(30) Priority: 19.03.2024 JP 2024043572
(43) Date of publication of application: 24.09.2025
(73) Proprietor: JEOL Ltd., Akishima, Tokyo 196-8558 (JP)
(72) Inventor: KIMURA, Tatsuhito, Tokyo, 196-8558 (JP); SASAKI, Yoshikazu, Tokyo, 196-8558 (JP); KOZUKA, Munehiro, Tokyo, 196-8558 (JP)
(74) Representative: Boult Wade Tennant LLP

(56) References cited:
- EP-A1- 4 404 234
- KR-A- 20220 093 286
- US-A1- 2018 342 369
- US-A1- 2018 358 201
- US-A1- 2020 051 775
- US-A1- 2022 319 802
- US-A1- 2023 386 779
- US-B1- 11 658 001

## Description

### BACKGROUND OF THE INVENTION

### 1. Field of the Invention

The present invention relates to a jig and, more particularly, to a jig for use with an ion milling apparatus using an ion beam.

### 2. Description of the Related Art

Cross Section Polisher (a trademark registered) for milling sample cross sections is known as apparatus for milling samples using an ion beam. As disclosed in Patent document 1, Cross Section Polisher is an apparatus for milling a sample using a broad ion beam and a shielding material. With Cross Section Polisher, a sample is so set as to protrude approximately 20 to 100 micrometers from the shielding material, and the sample is irradiated with a broad ion beam, whereby the portion of the sample protruding from the shielding material is milled. Patent document 2 discloses a sample holder system includes a sample holder and a sample adjusting unit. The sample holder includes a shielding plate, a holder body, a holding portion, and a fastening mechanism. The fastening mechanism fastens the holding portion to the holder body, the fastening mechanism preventing the holding portion from swinging when the holding portion is fastened to the holder body. The sample adjusting unit includes a position adjusting jig that comes into contact with the holding portion, and a swinging mechanism that supports the position adjusting jig such that the position adjusting jig is swingable.

### Citation List

### Patent Documents

Patent document 1: JP-A-2023-107397
Patent document 2: US 2018/358201 A1

When a sample is attached to a sample holder for Cross Section Polisher, the sample is generally treated with tweezers but the sample to be milled may be brittle. Therefore, it is difficult to handle the sample with the tweezers, and sample damage may occur.

### SUMMARY OF THE INVENTION

One aspect of the jig associated with the present invention is used to mount a sample on a sample holder that is used for an ion milling apparatus which mills the portion of the sample protruding from a shielding material by irradiating the sample with an ion beam via the shielding material. The jig includes: a holder support portion providing support of the sample holder on which the shielding material is mounted; and a guide assembly having rails and a first slider assembly capable of moving along the rails and operative to move the sample to the sample holder. The guide assembly includes stoppers for stopping said first slider assembly such that said sample protrudes a first amount from said shielding material. The jig further comprises a reference surface for placing said shielding material in position. The first slider assembly has a first sample holding surface that pushes against said sample. The first slider assembly is stopped by said stoppers, said reference surface and said first sample holding surface are spaced apart a distance equal to said first amount of protrusion from one another.

With this jig, the sample can be placed onto the sample holder to which the shielding material has been mounted by moving the first slider assembly along the rails. Accordingly, with this jig, the possibility that the sample will be destroyed can be reduced as compared with the case where the sample is gripped with tweezers, for example, and placed on the sample holder. Consequently, the sample can be mounted on the sample holder with greater ease.

### BRIEF DESCRIPTION OF THE DRAWINGS

FIG. 1 is a schematic perspective view of a jig associated with one embodiment of the present invention.
FIG. 2 is a schematic perspective view of a slider assembly.
FIG. 3 is a schematic perspective view of a guide assembly.
FIG. 4 is a schematic cross-sectional view of the jig of FIG. 1.
FIG. 5 is a schematic cross-sectional view of an elevating and lowering mechanism.
FIG. 6 is a flowchart illustrating one example of method of attaching a sample on a sample holder.
FIGS. 7-9 are perspective views illustrating a sequence of operations for attaching the sample on the sample holder.
FIG. 10 is a sequence of cross-sectional views illustrating a process sequence for attaching the sample on the sample holder.
FIGS. 11-13 are perspective views illustrating a sequence of operations for attaching the sample on the sample holder.
FIG. 14 is a schematic view illustrating the sequence of operations for attaching the sample on the sample holder.
FIGS. 15 and 16 are perspective views illustrating steps of attaching the sample on the sample holder.
FIG. 17 is a diagram illustrating a method of milling the sample by the use of an ion beam milling apparatus.
FIG. 18 is a cross-sectional view of a modification of the jig of FIG. 4.
FIG. 19 is a cross-sectional view of another modification of the jig of FIG. 4.
FIG. 20 is a cross-sectional view of a further modification of the jig of FIG. 4.
FIG. 21 is a cross-sectional view of a modification of the sample holder of FIG. 4.
FIG. 22 is a schematic perspective view of a jig associated with a third modification.

### DETAILED DESCRIPTION OF THE INVENTION

The preferred embodiments of the present invention are hereinafter described in detail with reference to the drawings. Note that the embodiments provided below are not intended to unduly restrict the contents of the present invention delineated by the claims and that not all the configurations set forth below are essential constituents of the present invention.

### 1. Jig

### 1.1 Structure of Jig

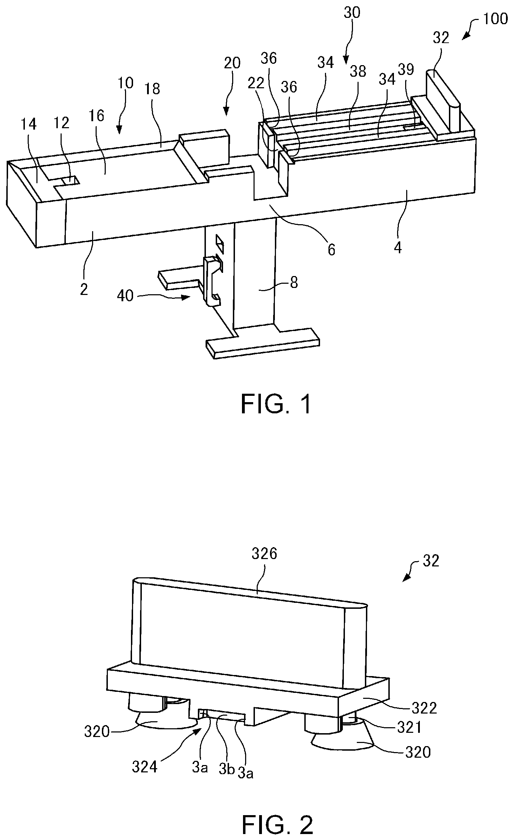

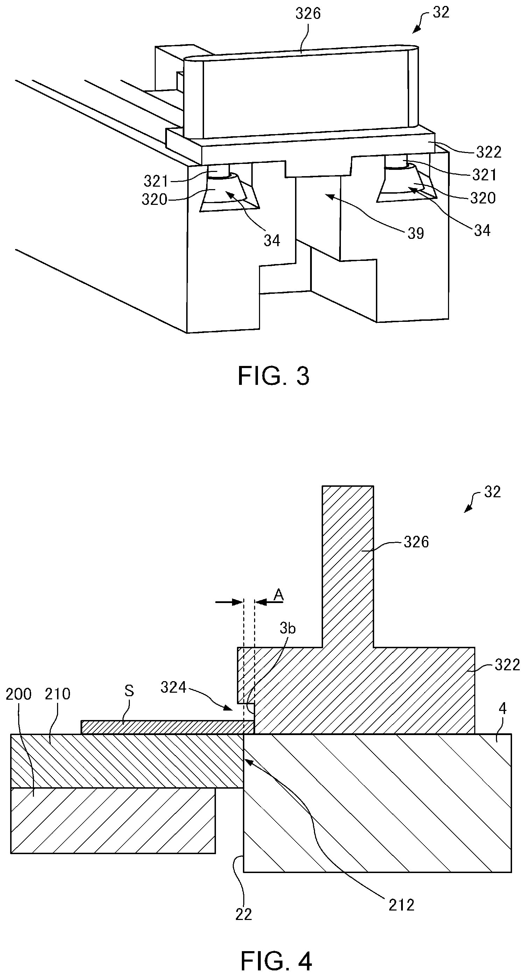

A jig associated with one embodiment of the present invention is first described by referring to FIG. 1, which is a schematic perspective view of the jig, 100. The jig 100 helps to mount a sample on a sample holder 200 (FIG. 4) for Cross Section Polisher which is an ion milling apparatus for milling the sample by irradiating it with an ion beam via a shielding material and milling the portion of the sample protruding from the shielding material. The shielding material is a plate-like member.

Referring still to FIG. 1, the jig 100 includes a material support stand 10, a holder support portion 20 for supporting the sample holder, a guide assembly 30, and an elevating and lowering mechanism 40.

Furthermore, the jig 100 includes a first beam 2 on which the material support stand 10 is mounted, a second beam 4 on which the guide assembly 30 is mounted, a base portion 6 on which the holder support portion 20 is mounted, and a pole 8 on which the elevating and lowering mechanism 40 is mounted. The first beam 2 and the second beam 4 extend from the base portion 6 in mutually opposite directions. The pole 8 is connected to the base portion 6 and provided with the elevating and lowering mechanism 40. The first beam 2, the second beam 4, and the base portion 6 are supported by the pole 8 so as to be capable of being elevated and lowered.

A material which is placed on the material support stand 10 and which is to be attached to the sample holder is prepared by stamping the material with a stamping machine. The material support stand 10 is provided with a cutout 12 that can be inserted into the pedestal of the stamping machine. A material formed into a desired shape and fragments of the material can be separated by inserting the pedestal of the stamping machine into the cutout 12 and stamping the material with the stamping machine. The material support stand 10 may have a recess conforming in shape with the material to facilitate setting the material on the cutout 12. The material support stand 10 has a placement surface 16 on which the material is placed. Fringes 18 higher in position than the placement surface 16 are formed around it.

The material support stand 10 includes a cap 14 that can be mounted on and removed from the first beam 2 with magnets, for example. The material support stand 10 is elevatable, i.e., the height of the material support stand 10 in the jig 100 can be varied. The material support stand 10 can be elevated and lowered by elevating and lowering the first beam 2 by means of the elevating and lowering mechanism 40.

The sample holder is placed on the holder support portion 20. The support portion 20 has a recess which is formed in the base portion 6 and which is so shaped that the sample holder fits into the recess. The support portion 20 has a reference surface 22 for placing the shielding material in position and is located at ends of rails 34 in the guide assembly 30. The shielding material can be placed in position by pushing it against the reference surface 22.

The guide assembly 30 guides the sample to the sample holder and includes a slider assembly 32, the two rails 34, and two stoppers 36. The slider assembly 32 can move along the two rails 34 which extend parallel to each other. A groove 38 for guiding the sample is formed between the two rails 34.

A cutout 39 into which the pedestal of the stamping machine can be inserted is formed in the path of movement of the slider assembly 32. For example, the cutout 39 is formed between the two rails 34 and in the bottom surface of the groove 38. The cutout 39 is formed by cutting out an end portion of the second beam 4. The guide assembly 30 permits the sample to be guided from the pedestal inserted in the cutout 39 to the sample holder.

The stoppers 36 are mounted at the front ends of the two rails 34, respectively, which are closer to the holder support portion 20. In the illustrated example, each stopper 36 is a plate-like member that plugs the front end of the respective one of the rails 34. Because the slider assembly 32 strikes the stoppers 36, the slider assembly 32 can be brought to a stop in position.

The first beam 2, the second beam 4, and the base portion 6 are fabricated integrally and can be elevated and lowered by the elevating and lowering mechanism 40 mounted on the pole 8. The elevating and lowering mechanism 40 permits the height of the material support stand 10 to be varied.

### 1.2. Guide Assembly

FIG. 2 is a schematic perspective view of the slider assembly 32. FIG. 3 is a schematic perspective view of the guide assembly 30. As shown in FIG. 2, the slider assembly 32 includes two rotating bodies 320, a base portion 322, a sample holding portion 324, and a grip portion 326. The two rotating bodies 320 are connected to the bottom surface of the base portion 322 via their respective pivotal members 321. The rotating bodies 320 rotate about their respective pivotal members 321.

The two rails 34 define two grooves which extend parallel to each other. One of the two rotating bodies 320 fits in one of the two rails 34, while the other rotating body 320 fits in the other rail 34. Consequently, the slider assembly 32 can move along the two rails 34. Each rail 34 has an open rear end and so the slider assembly 32 can be mounted on and removed from the two rails 34. If the user pushes the slider assembly 32, it moves along the rails 34.

The sample holding portion 324 is formed between the two rotating bodies 320 and protrudes downwardly from the base portion 322. The sample holding portion 324 fits in the groove 38 formed between the two rails 34.

The slider assembly 32 does not need to have the rotating bodies 320 if it can move along the rails 34 in a manner not illustrated. For example, the assembly may have a member that slides along the rails 34. In addition, if the slider assembly 32 can be moved along the rails 34 in a manner not illustrated, no restrictions are imposed on the structure of the guide assembly 30.

The sample holding portion 324 has two guide surfaces 3a for laterally guiding the sample to inhibit its rotation and a sample holding surface 3b pushing against the rear end of the sample. The orientation of the sample can be maintained constant by squeezing the sample between the two guide surfaces 3a. The sample can be moved by pushing against the sample by means of the sample holding surface 3b. The sample holding portion 324 is provided with a recess for holding the sample. The two guide surfaces 3a and the sample holding surface 3b are defined by the inner surface of the recess.

The grip portion 326 permits a user to grip it and protrudes upwardly from the base portion 322. When the user grips the grip portion 326 and causes the slider assembly 32 to slide, the slider assembly 32 moves along the two rails 34.

FIG. 4 is a schematic cross-sectional view of the jig 100 and illustrates a state in which the slider assembly 32 strikes on the stoppers 36 and comes to a stop. If the sample S is moved until the slider assembly 32 strikes on the stoppers 36 and comes to a halt as shown in FIG. 4, the sample S is placed on a shielding material 210 which, in turn, is mounted on the sample holder 200. At this time, the sample S protrudes an amount of A from the shielding material 210. That is, the stoppers 36 stop the slider assembly 32 in such a way that the sample S protrudes the amount of A from the shielding material 210.

The shielding material 210 has an end 213 in contact with the reference surface 22. Therefore, the position of the end 212 of the shielding material 210 is the position of the reference surface 22. The sample holding surface 3b pushes against the rear end of the sample S. The position of the sample holding surface 3b is so set that if the sample S is moved until the slider assembly 32 strikes on the stoppers 36 and comes to a halt, the distance between the reference surface 22 and the sample holding surface 3b equals the amount of protrusion A.

### 1.3. Elevating and Lowering Mechanism

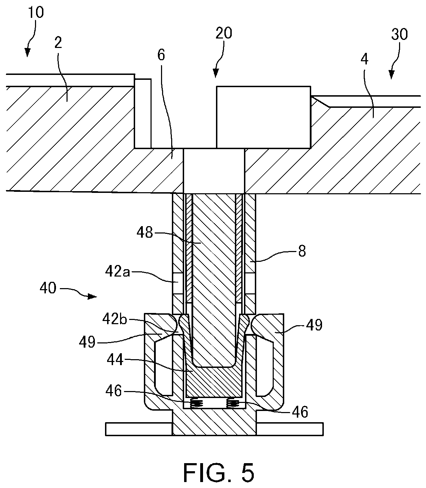

FIG. 5 is a schematic cross-sectional view of the elevating and lowering mechanism 40, which includes a first slit 42a, a second slit 42b, a stopper 44, springs 46, a pivotal member 48, and a stopper-pushing member 49.

The first slit 42a and the second slit 42b are formed in the pole 8. The first slit 42a is located above the second slit 42b, i.e., closer to the holder support portion 20. The stopper 44 is so formed that it is caught either in the first slit 42a or in the second slit 42b. By causing the stopper 44 to be caught in the first slit 42a, the stopper 44 is secured at a position corresponding to the height of the first slit 42a. Similarly, by causing the stopper 44 to be caught in the second slit 42b, the stopper 44 is secured at a position corresponding to the height of the second slit 42b. A push-up force is applied to the stopper 44 by the springs 46.

The axial member 48 is connected to the base portion 6 and supported by the stopper 44. Therefore, the first beam 2, the second beam 4, and the base portion 6 are secured at their positions corresponding to the height of the first slit 42a by catching the stopper 44 in the first slit 42a. Similarly, the first beam 2, the second beam 4, and the base portion 6 are secured at positions corresponding to the height of the second slit 42b by catching the stopper 44 in the second slit 42b. The height of the first beam 2, second beam 4, and base portion 6 when the stopper 44 is caught in the first slit 42a is lower than that when the stopper 44 is caught in the second slit 42b.

The stopper-pushing member 49 pushes against the stopper 44 caught in the second slit 42b. As a result, the stopper 44 flexes and comes out of the second slit 42b. The force of the springs 46 pushes the stopper 44 upward so that the stopper 44 is caught in the first slit 42a. Where the stopper 44 caught in the first slit 42a should be caught in the second slit 42b, the base portion 6 is pushed in downwards. This brings the stopper 44 out of the first slit 42a and causes the stopper 44 to be caught in the second slit 42b.

### 2. Operation

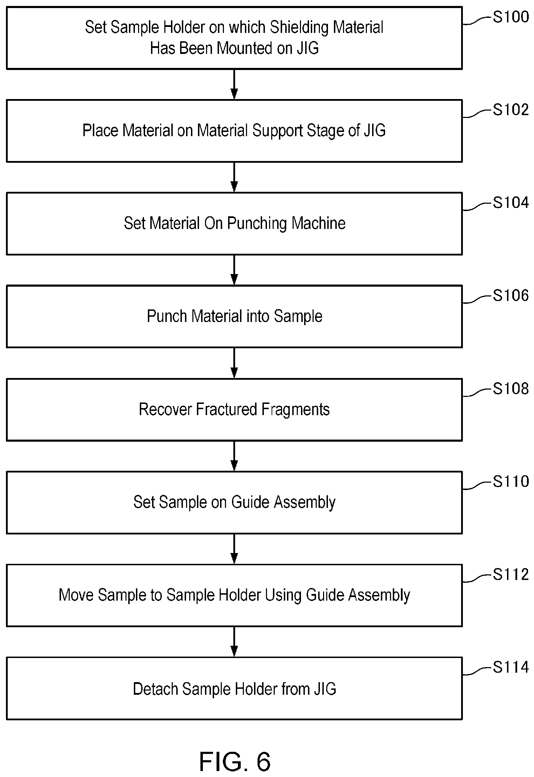

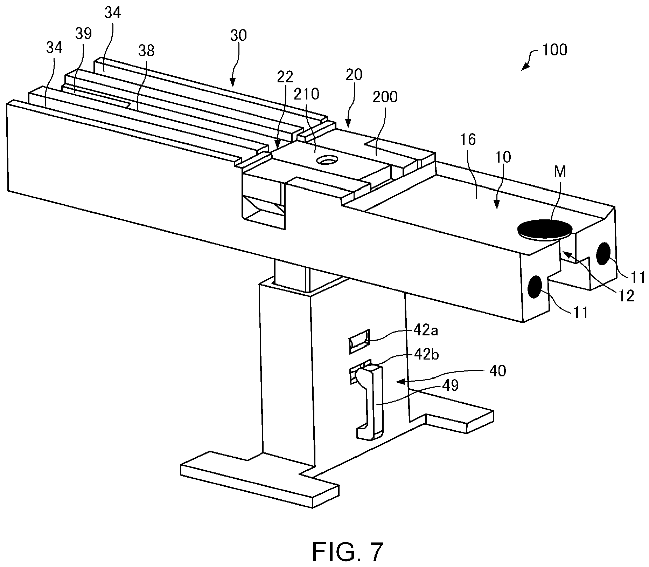

FIG. 6 is a flowchart illustrating one example of method of mounting the sample S to the sample holder 200. FIGS. 7-16 illustrate process steps of mounting the sample S to the sample holder 200. First, as shown in FIG. 7, the sample holder 200 to which the shielding material 210 has been attached is set on the jig 100 (S100). In particular, the sample holder 200 is placed on the support portion 20 of the jig 100. At this time, the shielding material 210 is placed in position by pushing it against the reference surface 22.

Then, a material M is placed on the cutout 12 of the material support stand 10 (S102). At this time, the stopper 44 is caught in the first slit 42a and the material support stand 10 is raised. The cap 14 is removed.

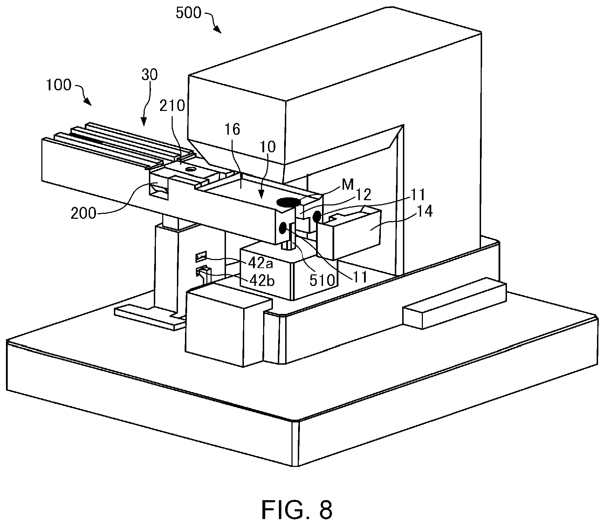

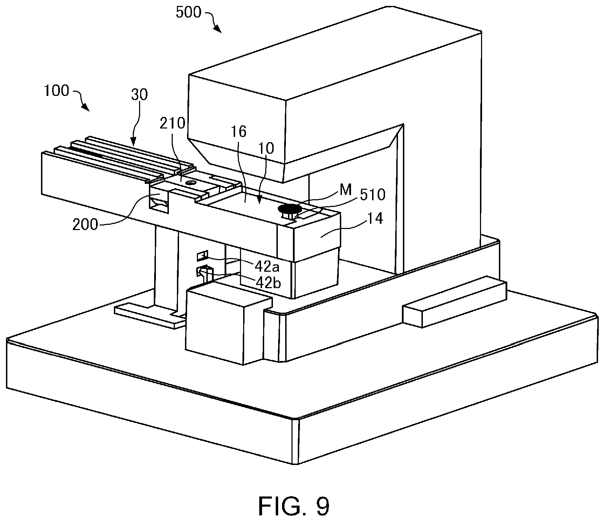

Then, as shown in FIGS. 8 and 9, the cutout 12 is inserted into the pedestal 510 of a punching machine 500. The material M is set on the punching machine 500 (S104).

During the step of setting the material M on the punching machine 500, the cutout 12 is first inserted into the pedestal 510 of the punching machine 500 as shown in FIG. 8. When the material support stand 10 is raised, the placement surface 16 on which the material M is placed is flush with or higher than the top surface of the pedestal 510. Therefore, the pedestal 510 can be placed below the material M by inserting the pedestal 510 into the cutout 12. Then, the cap 14 is secured to the material support stand 10 with magnets 11, whereby the cutout 12 is closed by the cap 14. Then, as shown in FIG. 9, the base portion 6 is pushed in downwards so that the stopper 44 is caught in the second slit 42b. Consequently, the material support stand 10 is lowered, so that the placement surface 16 is lower than the pedestal 510. As a result, the material M is placed on the pedestal 510. Because of the processing steps described so far, the material M can be set on the pedestal 510 of the punching machine 500.

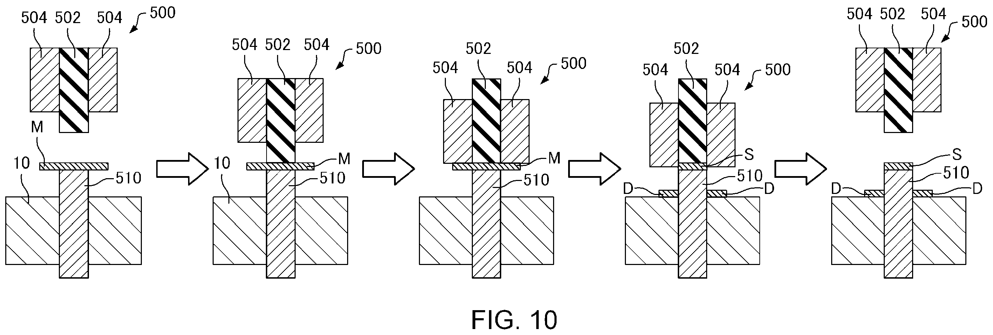

Then, as shown in FIG. 10, the material M is punched into a desired shape, thus forming a sample S (S106). FIG. 10 illustrates a method of forming the sample S using the punching machine 500 which includes a hold-down member 502 and a blade 504 as shown. When the material M is set on the pedestal 510 of the punching machine 500, the hold-down member 502 and the blade 504 are located above the material M. The front end of the hold-down member 502 has the same planar shape as the top surface of the pedestal 510. The blade 504 surrounds the periphery of the hold-down member 502.

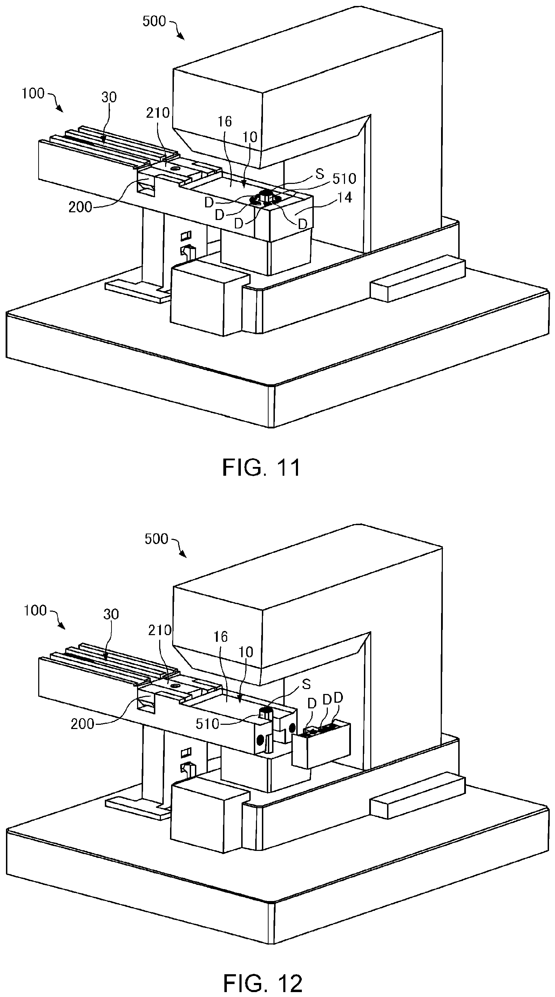

First, the hold-down member 502 and the blade 504 are lowered while the material M is placed on the pedestal 510. This brings the hold-down member 502 into contact with the material M, causing the hold-down member 502 to hold the material M down against the pedestal 510. Further lowering of the blade 504 fractures the portion of the material M protruding from the pedestal 510 by the shearing force between the blade 504 and the pedestal 510. The portion of the material M which has been held down by the hold-down member 502 is left on the pedestal 510 and, therefore, the material M can be formed into a desired shape. As a result, the sample S of the desired shape can be formed. For example, the planar shape of the material M prior to the punching is a circle having a diameter of approximately 10 mm. The planar shape of the sample S shaped by the punching machine 500 is a square of 5 mm x 5 mm. As shown in FIG. 11, the crushed fragments D of the material M are scattered on the material support stand 10.

Then, as shown in FIG. 12, the crushed fragments D are recovered (S108). The crushed fragments D scattered on the material support stand 10 are collected onto the cap 14 as shown. Because the material support stand 10 is provided with the fringes 18 higher than the placement surface 16, the fragments D can be prevented from dropping from the material support stand 10. Then, the cap 14 is removed while the fragments D are placed on the cap 14. Consequently, the fragments D can be recovered.

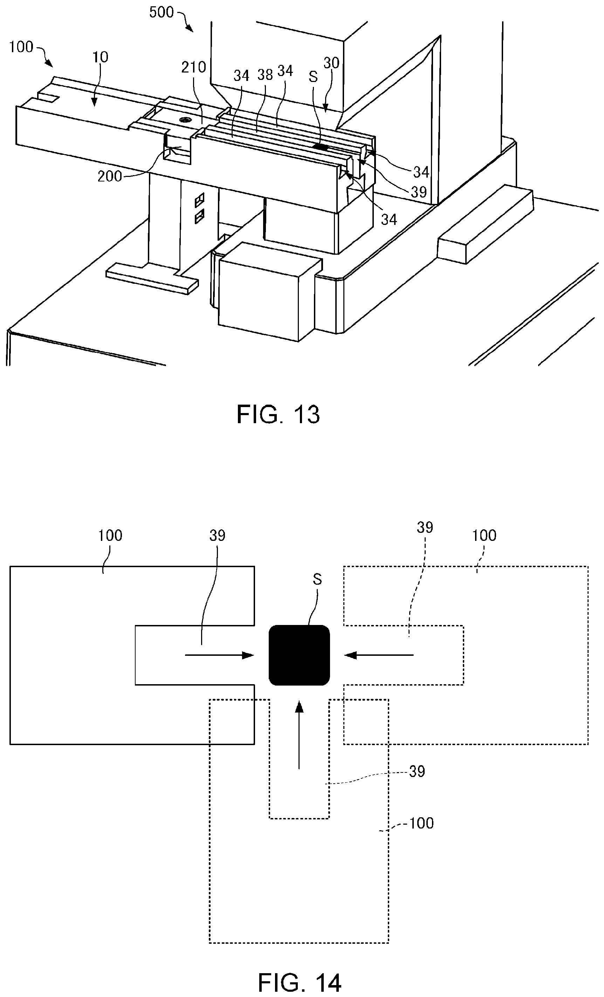

Then, as shown in FIG. 13, the sample S is set on the guide assembly 30 (S110). In particular, the pedestal 510 is first disengaged from the cutout 12 while the sample S is placed on the pedestal 510. Then, the orientation of the jig 100 is varied and the pedestal 510 is inserted into the cutout 39. In consequence, the sample S placed on the pedestal 510 is placed in the groove 38 between the two rails 34. Thus, the sample S can be set on the guide assembly 30.

As shown in FIG. 14, with the jig 100, the cutout 39 can be inserted into the pedestal 510 from any of three directions. Therefore, a surface to be milled can be selected from three cross sections according to the state of the sample S.

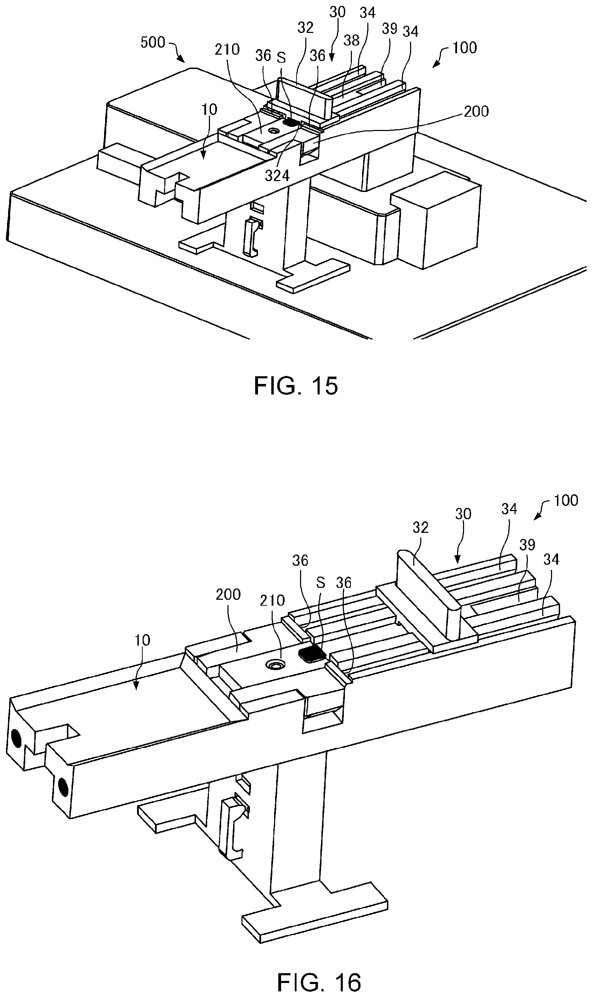

Then, as shown in FIG. 15, the sample S is moved to the sample holder 200 using the guide assembly 30 (S112). Specifically, the slider assembly 32 is mounted to the two rails 34. More specifically, one of the two rotating bodies 320 is fitted to one of the two rails 34, while the other rotating body 320 is fitted to the other rail 34. Since the rear ends of the rails 34 are open, the rotating bodies 320 are entered from the rear ends of the rails 34. Thus, the rotating bodies 320 can be fitted to the rails 34.

Then, the slider assembly 32 is moved along the two rails 34 from the rear ends to the front ends of the rails 34. Because the stoppers 36 are disposed at the front ends of the rails 34, the slider assembly 32 strikes on the stoppers 36 and comes to a stop. By moving the slider assembly 32 from the rear ends to the front ends of the rails 34, the sample S located in the path of movement of the slider assembly 32 can be recovered at the sample holding portion 324, and the sample S can be moved to the sample holder 200. At this time, since the sample S is accommodated in the sample holding portion 324, the slider assembly 32 can move the sample S to the sample holder 200 without rotating the sample S, i.e., while retaining the orientation of the sample S.

When the slider assembly 32 strikes on the stoppers 36 and comes to a stop, the sample S is so placed as to protrude the amount A from the shielding material 210 as shown in FIG. 4. Consequently, the sample S can be placed on the sample holder 200 while the sample S protrudes the amount A from the shielding material 210 as shown in FIG. 16.

Then, the sample S is secured to the sample holder 200, and the holder 200 is removed from the jig 100 (S114). The sample S is secured to the sample holder 200 using a leaf spring, screws, adhesive, or other means (not shown). Furthermore, the sample S may be secured to the sample holder 200 while sandwiched between the shielding material 210 and a sample support plate. After securing the sample S to the sample holder 200, the holder 200 is removed from the jig 100. Because of the processing steps described so far, the sample S can be mounted to the sample holder 200.

### 3. Milling of Sample

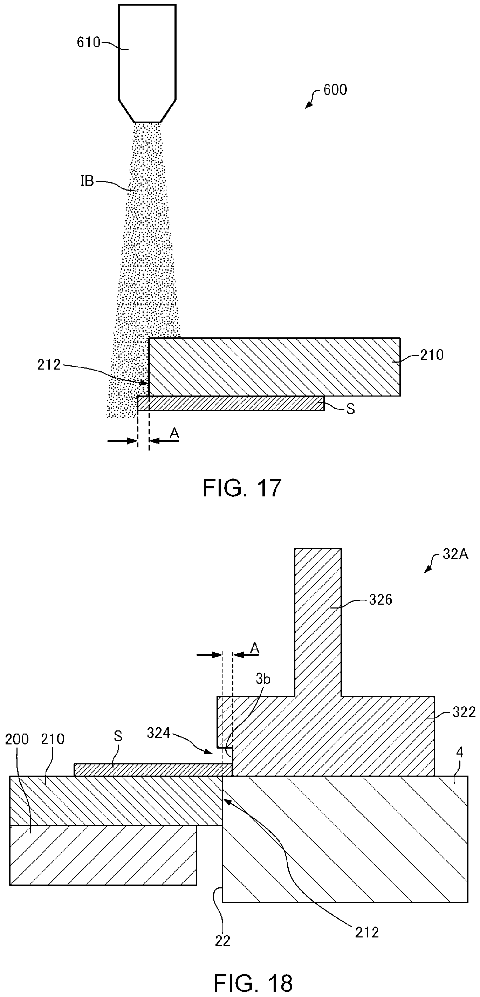

FIG. 17 illustrates a method of milling the sample S by the use of an ion beam milling apparatus 600. For the sake of convenience, the sample holder 200 is not shown in FIG. 17. The ion beam milling apparatus 600 is Cross-Section Polisher as shown. The milling apparatus 600 includes an ion source 610 emitting an ion beam IB which is made to strike the sample S via the shielding material 210. Consequently, the portion of the sample S protruding from the shielding material 210 can be etched.

The use of the jig 100 as described above permits precise control of the amount of protrusion of the sample S from the shielding material 210 and so the milling position on the sample S can be determined accurately.

### 4. Advantageous Effects

The jig 100 is used to mount the sample S to the sample holder 200 for use with the ion milling apparatus 600 which irradiates the sample S with the ion beam IB via the shielding material 210 and which mills the portion of the sample S protruding from the shielding material 210. The jig 100 includes: the holder support portion 20 for supporting the sample holder 200 on which the shielding material 210 is mounted; and the guide assembly 30 including the rails 34 and the slider assembly 32 capable of moving along the rails 34 and operative to move the sample S to the sample holder 200.

Therefore, in the jig 100, the sample S can be placed on the sample holder 200 to which the shielding material 210 has been mounted by moving the slider assembly 32 along the rails 34. Accordingly, with the jig 100, the possibility of destruction of the sample S can be reduced as compared with the case where the sample S is gripped with tweezers and placed on the sample holder 200. Hence, the sample S can be mounted on the sample holder 200 with greater ease.

For example, all-solid-state batteries are made of brittle materials and easily break and so they are difficult to handle with tweezers. Furthermore, all-solid-state batteries include lithium which exhibits high reactivity with air and, therefore, all-solid-state batteries need to be handled within a glove box. In this way, it is difficult to attach an all-solid-state battery to the sample holder 200 with tweezers.

On the other hand, with the jig 100, the sample S can be arranged on the sample holder 200 by moving the slider assembly 32 along the rails 34. Accordingly, if the sample S is a brittle material and easily breaks such as an all-solid-state battery, the sample S can be easily attached to the sample holder 200. Furthermore, with the jig 100, manipulations within a glove box are easy to perform because the sample S can be arranged on the sample holder 200 by moving the slider assembly 32 along the rails 34.

The sample S to which the jig 100 is directed is not restricted to all-solid-state batteries. Rather, the jig 100 can be used when various types of samples such as metallic samples and ceramic samples are attached to the sample holder 200.

In the jig 100, the guide assembly 30 includes the stoppers 36 for stopping the slider assembly 32 such that the sample S protrudes the amount A from the shielding material 210. Therefore, with the jig 100, the sample S can be placed in position so that the sample S protrudes the amount A from the shielding material 210 by moving the slider assembly 32 along the rails 34 until stopped by the stoppers 36. Consequently, with the jig 100, the sample S can be mounted to the sample holder 200 easily.

The jig 100 includes the reference surface 22 for placing the shielding material 210 in position. The slider assembly 32 has the sample holding surface 3b that pushes against the sample S. When the slider assembly 32 is brought to a stop by the stoppers 36, the distance between the reference surface 22 and the sample holding surface 3b is equal to the amount of protrusion A. Therefore, with the jig 100, the sample S can be placed in position such that the sample S protrudes the amount A from the shielding material 210 by moving the slider assembly 32 along the rails 34 until stopped by the stoppers 36.

The jig 100 includes the slider assembly 32 having the path of movement in which there is formed the cutout 39 capable of being inserted into the pedestal 510 of the punching machine 500 that punches the material M into the sample S. Therefore, with the jig 100, the sample S which has been punched into a desired shape with the punching machine 500 can be placed on the sample holder 200 without gripping the sample S with tweezers or the like.

The jig 100 includes the material support stand 10 on which the material M is placed. The support stand 10 is elevatable and provided with the cutout 12 capable of being inserted into the pedestal 510 of the punching machine 500 which punches the material M into the sample S. Therefore, the jig 100 facilitates placing the material M on the pedestal 510 of the punching machine 500.

### 5. Modifications

### 5.1. First Modification

FIGS. 18, 19, and 20 illustrate a modification of the jig 100. In the above embodiment, the guide assembly 30 has one slider assembly 32. On the other hand, the guide assembly 30 of FIGS. 18, 19, and 20 may have a first slider assembly 32A, a second slider assembly 32B, and a third slider assembly 32C. In this way, the guide assembly 30 has plural slider assemblies, and one slider assembly is selected from the plural slider assemblies and moved along the rails 34.

With respect to the first slider assembly 32A of FIG. 18, when it is stopped by the stoppers 36, the distance between the reference surface 22 and the sample holding surface 3b is equal to the amount of protrusion A. Accordingly, the use of the first slider assembly 32A permits the sample S to be placed in position so that the sample S protrudes the amount A from the shielding material 210.

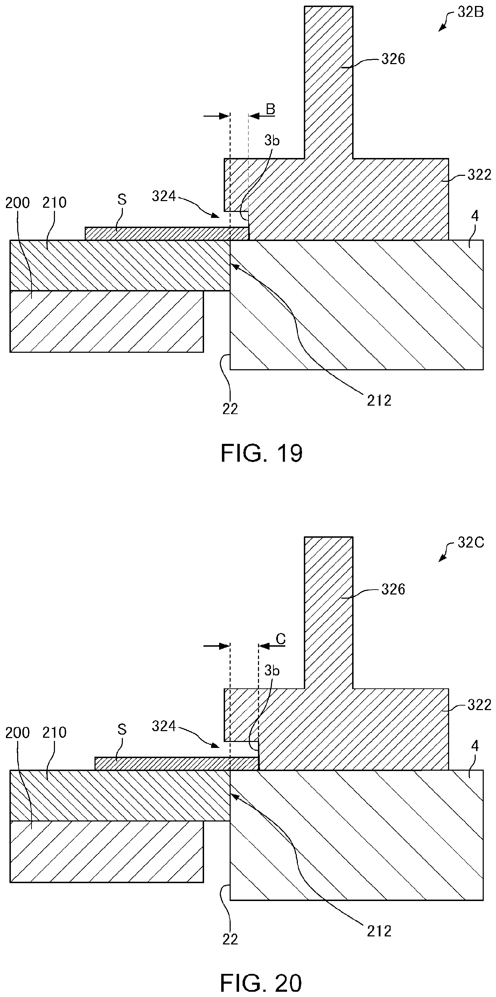

With respect to the second slider assembly 32B of FIG. 19, when it is stopped by the stoppers 36, the distance B between the reference surface 22 and the sample holding surface 3b is different from the amount of protrusion A. Accordingly, the use of the second slider assembly 32B permits the sample S to be placed in position such that the sample S protrudes the amount B from the shielding material 210.

With respect to the third slider assembly 32C of FIG. 20, when it is stopped by the stoppers 36, the distance C between the reference surface 22 and the sample holding surface 3b is different both from the amount of protrusion A and from the amount of protrusion B. Accordingly, the use of the third slider assembly 32C allows the sample S to be placed in position in such a way that the sample S protrudes the amount C from the shielding material 210.

The first slider assembly 32A, the second slider assembly 32B, and the third slider assembly 32C are similar in shape except for the depth of the recess in the sample holding portion 324, i.e., the position of the sample holding surface 3b.

Because the guide assembly 30 has the first slider assembly 32A, the second slider assembly 32B, and the third slider assembly 32C, it is possible that a slider assembly corresponding to a desired amount of protrusion is selected and used. Therefore, the amount of protrusion of the sample S from the shielding material 210 can be set to a desired amount.

In the foregoing description, the guide assembly 30 includes the three slider assemblies. The number of slider assemblies may be two or four or more.

### 5.2. Second Modification

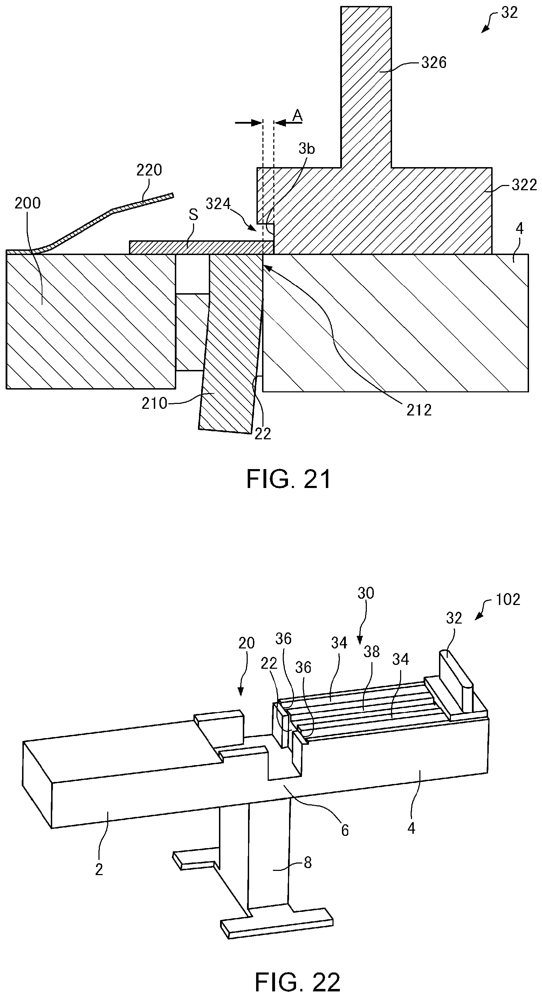

FIG. 21 illustrates a modification of the sample holder 200. In the above embodiment, as shown in FIG. 4, the sample S is placed on the shielding material 210 in the sample holder 200. Alternatively, as shown in FIG. 21, the sample S may be placed both on the sample holder 200 and on the shielding material 210. In the sample holder 200 of FIG. 21, the sample S is fastened to the sample holder 200 by a leaf spring 220. In the processing step S112 of moving the sample S to the sample holder 200 by the use of the above-described guide assembly 30 shown in FIG. 6, the slider assembly 32 is moved while the leaf spring 220 is open and the sample S is placed on the sample holder 200. In this way, with the jig 100, the sample S can be mounted on various sample holders.

### 5.3. Third Modification

FIG. 22 is a schematic perspective view of a jig 102 associated with a third modification. Those members of the jig 102 which are similar in function to their respective counterparts of the above-described jig 100 are hereinafter indicated by the same reference numerals as in the foregoing figures and a detailed description thereof is omitted below.

As shown in FIG. 1, the above-described jig 100 has the material support stand 10 for setting the material M on the punching machine 500 and the elevating and lowering mechanism 40 for elevating and lowering the support stand 10. The jig 100 is provided with the cutout 39 for setting the sample S on the guide assembly 30 after the sample S is prepared by the punching machine 500. That is, the jig 100 is used to set the sample S prepared by the punching machine 500 onto the sample holder 200.

On the other hand, the jig 102 has neither the material support stand 10 nor the elevating and lowering mechanism 40 as shown in FIG. 22. Furthermore, the jig 102 is not provided with the cutout 39. With the jig 102, the sample S is put into the groove 38 in the guide assembly 30 with tweezers or the like. This permits the sample S to be placed in position such that the sample S protrudes the amount A from the shielding material 210 by moving the slider assembly 32 in the same manner as with the jig 100 described above.

## Claims

1. A jig (100) for mounting a sample (S) on a sample holder used for an ion milling apparatus (600) which mills the portion of the sample protruding from a shielding material by irradiating the sample (S) with an ion beam via the shielding material, said jig (100) comprising:
a holder support portion (20) providing support of the sample holder on which the shielding material is mounted; and
a guide assembly (30) including rails (34) and a first slider assembly (32A) capable of moving along the rails (34) and operative to move the sample (S) to the sample holder, **characterized in that** said guide assembly (30) includes stoppers (36) for stopping said first slider assembly (32A) such that said sample (S) protrudes a first amount from said shielding material,
the jig (100) further comprising a reference surface (22) for placing said shielding material in position;
wherein said first slider assembly (32A) has a first sample holding surface that pushes against said sample (S); and
wherein when the first slider assembly (32A) is stopped by said stoppers (36), said reference surface (22) and said first sample holding surface are spaced apart a distance equal to said first amount of protrusion from one another.

2. A jig (100) as set forth in claim 1,
wherein said guide assembly (30) has a second slider assembly (32B) capable of moving along said rails (34) and operative to move said sample (S) to said sample holder along the rails (34); and
wherein said stoppers (36) bring the second slider assembly (32B) to a stop such that the sample (S) protrudes a second amount different from said first amount from said shielding material.

3. A jig (100 as set forth in claim 2,
wherein said second slider assembly (32B) has a second sample holding surface that pushes against said sample (S); and
wherein when the second slider assembly (32B) is brought to a stop by said stoppers (36), said reference surface (22) and the second sample holding surface are spaced apart a distance equal to said second amount of protrusion from one another.

4. A jig (100) as set forth in claim 1, further comprising a material support stand (10) which is elevatable and on which a material is placed, the material support stand (10) being provided with a cutout (12) capable of being inserted into a pedestal (510) of a punching machine that punches the material into said sample (S).

5. A jig (100) as set forth in any one of claims 1 to 3, wherein said first slider assembly (32A) has a path of movement in which there is formed a cutout capable of being inserted into a pedestal of a punching machine that punches the material into said sample (S).

## Patentansprüche

1. Spannvorrichtung (100) zum Anbringen einer Probe (S) auf einem Probenhalter, der für eine Ionenstrahlätzeinrichtung (600) verwendet wird, die den aus einem Abschirmmaterial herausragenden Abschnitt der Probe abträgt, indem die Probe (S) durch das Abschirmmaterial hindurch mit einem Ionenstrahl bestrahlt wird, wobei die Spannvorrichtung (100) umfasst:
einen Halterstützabschnitt (20), der die Abstützung für den Probenhalter bereitstellt, auf dem das Abschirmmaterial angebracht ist; und
eine Führungsbaugruppe (30), die Schienen (34) und eine erste Gleiterbaugruppe (32A), die zur Bewegung entlang der Schienen (34) imstande ist und betriebsfähig ist, die Probe (S) zum Probenhalter zu bewegen, einschließt,
**dadurch gekennzeichnet, dass** die Führungsbaugruppe (30) Anschläge (36) zum Anhalten der ersten Gleiterbaugruppe (32A) einschließt, sodass die Probe (S) um einen ersten Betrag aus dem Abschirmungsmaterial hervorsteht,
wobei die Spannvorrichtung (100) ferner eine Bezugsfläche (22) zum Positionieren des Abschirmmaterials umfasst;
wobei die erste Gleiterbaugruppe (32A) eine erste Probenhaltefläche aufweist, die gegen die Probe (S) drückt; und
wobei, wenn die erste Gleiterbaugruppe (32A) durch die Anschläge (36) angehalten wird, die Bezugsfläche (22) und die erste Probenhaltefläche einen Abstand voneinander aufweisen, der gleich dem ersten Betrag des Hervorstehens ist.

2. Spannvorrichtung (100) nach Anspruch 1,
wobei die Führungsbaugruppe (30) eine zweite Gleiterbaugruppe (32B) aufweist, die zur Bewegung entlang der Schienen (34) imstande ist und betriebsfähig ist, die Probe (S) entlang der Schienen (34) zum Probenhalter zu bewegen, und;
wobei die Anschläge (36) die zweite Gleiterbaugruppe (32B) so zum Halten bringen, dass die Probe (S) um einen zweiten Betrag, der sich von dem ersten Betrag unterscheidet, aus dem Abschirmungsmaterial hervorsteht.

3. Spannvorrichtung (100) nach Anspruch 2,
wobei die zweite Gleiterbaugruppe (32B) eine zweite Probenhaltefläche aufweist, die gegen die Probe (S) drückt; und
wobei, wenn die zweite Gleiterbaugruppe (32B) durch die Anschläge (36) zum Halten gebracht wird, die Bezugsfläche (22) und die zweite Probenhaltefläche einen Abstand voneinander aufweisen, der gleich dem zweiten Betrag des Hervorstehens ist.

4. Spannvorrichtung (100) nach Anspruch 1, ferner umfassend einen Materialaufnahmeständer (10), der anhebbar ist und auf dem ein Material platziert wird, wobei der Materialaufnahmeständer (10) mit einer Aussparung (12) versehen ist, die imstande ist, in einen Sockel (510) einer Stanzmaschine eingeführt zu werden, die das Material in die Probe (S) stanzt.

5. Spannvorrichtung (100) nach einem der Ansprüche 1 bis 3, wobei die erste Gleiterbaugruppe (32A) eine Bewegungsbahn aufweist, in der eine Aussparung ausgebildet ist, die imstande ist, in einen Sockel einer Stanzmaschine eingeführt zu werden, die das Material in die Probe (S) stanzt.

## Revendications

1. Gabarit (100) pour monter un échantillon (S) sur un porte-échantillon utilisé pour un appareil de fraisage ionique (600) qui fraise la partie de l'échantillon faisant saillie depuis un matériau de protection en irradiant l'échantillon (S) avec un faisceau d'ions à travers le matériau de protection, ledit gabarit (100) comprenant :
une partie de support de dispositif de maintien (20) assurant le support du porte-échantillon sur lequel le matériau de protection est monté ; et
un ensemble de guidage (30) incluant des rails (34) et un premier ensemble curseur (32A) qui permet de se déplacer le long des rails (34) et fonctionnant pour déplacer l'échantillon (S) vers le porte-échantillon,
**caractérisé en ce que** ledit ensemble de guidage (30) inclut des butées (36) pour arrêter ledit premier ensemble curseur (32A) de telle sorte que ledit échantillon (S) fasse saillie d'une première quantité dudit matériau de protection,
le gabarit (100) comprenant en outre une surface de référence (22) pour placer ledit matériau de protection en position ;
dans lequel ledit premier ensemble curseur (32A) présente une première surface de maintien d'échantillon qui pousse contre ledit échantillon (S) ; et
dans lequel, lorsque le premier ensemble curseur (32A) est arrêté par lesdits butées (36), ladite surface de référence (22) et ladite première surface de maintien d'échantillon sont espacées d'une distance égale à ladite première quantité de saillie l'une de l'autre.

2. Gabarit (100) selon la revendication 1,
dans lequel ledit ensemble de guidage (30) présente un second ensemble curseur (32B) qui permet de se déplacer le long desdits rails (34) et permettant de déplacer ledit échantillon (S) vers ledit porte-échantillon le long des rails (34) ; et
dans lequel lesdits butées (36) amènent le second ensemble curseur (32B) à un arrêt de telle sorte que l'échantillon (S) fasse saillie d'une seconde quantité différente de ladite première quantité dudit matériau de protection.

3. Gabarit (100) selon la revendication 2,
dans lequel ledit second ensemble curseur (32B) présente une seconde surface de maintien d'échantillon qui pousse contre ledit échantillon (S) ; et
dans lequel, lorsque le second ensemble curseur (32B) est arrêté par lesdits butées (36), ladite surface de référence (22) et la seconde surface de maintien d'échantillon sont espacées d'une distance égale à ladite seconde quantité de saillie l'une de l'autre.

4. Gabarit (100) selon la revendication 1, comprenant en outre un statif de support de matériau (10) qui est réglable en hauteur et sur lequel un matériau est placé, le statif de support de matériau (10) étant pourvu d'une découpe (12) qui peut être insérée dans un socle (510) d'une machine à poinçonner qui poinçonne le matériau dans ledit échantillon (S).

5. Gabarit (100) selon l'une quelconque des revendications 1 à 3, dans lequel ledit premier ensemble curseur (32A) présente un chemin de mouvement dans lequel est formée une découpe qui peur être insérée dans un socle d'une machine à poinçonner qui poinçonne le matériau dans ledit échantillon (S).
